# EUROPEAN PATENT APPLICATION

(11) **EP 4 383 973 A1**
(43) Date of publication of application: **12.06.2024**
(21) Application number: 23206496.4
(22) Date of filing: 27.10.2023
(51) Int. Cl.: H05K 9/00

(54) **SOLID STATE DRIVE APPARATUS AND DATA STORAGE APPARATUS INCLUDING THE SAME**

(30) Priority: 08.12.2022 KR 20220170956
(71) Applicant: Samsung Electronics Co., Ltd., Suwon-si, Gyeonggi-do 16677 (KR)
(72) Inventor: KIM, Suin, 16677 Suwon-si (KR); KWAK, Insub, 16677 Suwon-si (KR); LEE, Hanhong, 16677 Suwon-si (KR); LEE, Sungki, 16677 Suwon-si (KR)
(74) Representative: Marks & Clerk LLP

(57) **Abstract**

A solid state drive apparatus includes a case including an upper wall and a lower wall, a substrate in the case and including a plurality of first connection pads in or on a first surface of the substrate facing the upper wall of the case, a first semiconductor chip on the first surface of the substrate, and a first shielding structure electrically connecting the upper wall of the case to the plurality of first connection pads, wherein the first shielding structure includes a plurality of first unit shielding structures surrounding the first semiconductor chip and spaced apart from each other with gaps therebetween, and wherein each of the plurality of first unit shielding structures includes an elastic body.

## Description

### BACKGROUND

The inventive concept relates to a solid state drive apparatus.

As electronic devices are miniaturized and have high performance, electronic devices are required to have a function capable of protecting electronic components from electromagnetic interference and electrostatic discharge (ESD).

### SUMMARY

The inventive concept provides a solid state drive apparatus with improved reliability.

The inventive concept provides a data storage apparatus including the solid state drive apparatus.

According to an aspect of the inventive concept, there is provided a solid state drive apparatus including a case including an upper wall and a lower wall, a substrate in the case and including a plurality of first connection pads provided in or on a first surface of the substrate facing the upper wall of the case, a first semiconductor chip on the first surface of the substrate, and a first shielding structure electrically connecting the upper wall of the case to the plurality of first connection pads, wherein the first shielding structure includes a plurality of first unit shielding structures surrounding the first semiconductor chip and spaced apart from each other with gaps therebetween, wherein each of the plurality of first unit shielding structures includes an elastic body.

According to another aspect of the inventive concept, there is provided a solid state drive apparatus including a case including an upper wall and a lower wall, a substrate in the case, and including a first surface facing the upper wall of the case, a second surface facing the lower wall of the case, and a plurality of first connection pads which are in or on the first surface and which are electrically grounded, a plurality of first semiconductor chips on the first surface of the substrate in a first accommodation space, a plurality of second semiconductor chips on the first surface of the substrate in a second accommodation space, an external connector extending from an edge of the substrate and extending outside of the case through an opening of the case, and a first shielding structure including a plurality of first unit shielding structures surrounding the plurality of first semiconductor chips, wherein the plurality of first unit shielding structures are spaced apart from each other and define a plurality of gaps therebetween, wherein the first accommodation space and the second accommodation space communicate with each other through the plurality of gaps of the first shielding structure, and wherein each of the plurality of first unit shielding structures includes a conductor electrically connecting the upper wall of the case to a corresponding first connection pad among the plurality of first connection pads, and an elastic body configured to provide a restoring force to the conductor.

According to another aspect of the inventive concept, there is provided a data storage apparatus including a rack including a socket, a solid state drive (SSD) apparatus connected to the socket, and a cooling fan adjacent the rack and configured to force an air flow, wherein the SSD apparatus includes a case including an upper wall and a lower wall, a substrate in the case and including a plurality of first connection pads in or on a first surface of the substrate facing the upper wall of the case, a first semiconductor chip on the first surface of the substrate, and a first shielding structure electrically connecting the upper wall of the case to the plurality of first connection pads, wherein the first shielding structure includes a plurality of first unit shielding structures surrounding the first semiconductor chip and spaced apart from each other with gaps therebetween, and wherein each of the plurality of first unit shielding structure includes an elastic body.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a perspective view illustrating a solid state drive (SSD) apparatus according to embodiments;
FIG. 2 is an exploded perspective view illustrating the SSD apparatus according to embodiments;
FIG. 3 is a plan view showing some components of the SSD apparatus according to embodiments;
FIG. 4 is a cross-sectional view of the SSD apparatus taken along the line X-X' of FIG. 1.
FIG. 5 is a cross-sectional view of the SSD apparatus taken along line Y-Y' of FIG. 1;
FIG. 6 is a cross-sectional view illustrating a first unit shielding structure of a first shielding structure according to embodiments;
FIG. 7 is a plan view illustrating an SSD apparatus according to embodiments;
FIG. 8 is a plan view illustrating an SSD apparatus according to embodiments;
FIG. 9 is a plan view illustrating an SSD apparatus according to embodiments;
FIG. 10 is a cross-sectional view showing an SSD apparatus according to embodiments;
FIG. 11 is a cross-sectional view showing an SSD apparatus according to embodiments;
FIG. 12 is a plan view illustrating some components of an SSD apparatus according to embodiments;
FIG. 13 is a cross-sectional view showing an SSD apparatus according to embodiments;
FIG. 14 is a cross-sectional view showing an SSD apparatus according to embodiments;
FIG. 15 is a plan view showing some components of an SSD apparatus according to embodiments;
FIG. 16 is a cross-sectional view illustrating an SSD apparatus according to embodiments;
FIG. 17 is a cross-sectional view showing an SSD apparatus according to embodiments; and
FIG. 18 is a configuration diagram illustrating a data storage apparatus according to embodiments.

### DETAILED DESCRIPTION

Hereinafter, example embodiments of the inventive concept will be described in detail with reference to the accompanying drawings. The same reference numerals are used for the same components in the drawings, and duplicate descriptions thereof may be omitted in the interest of brevity.

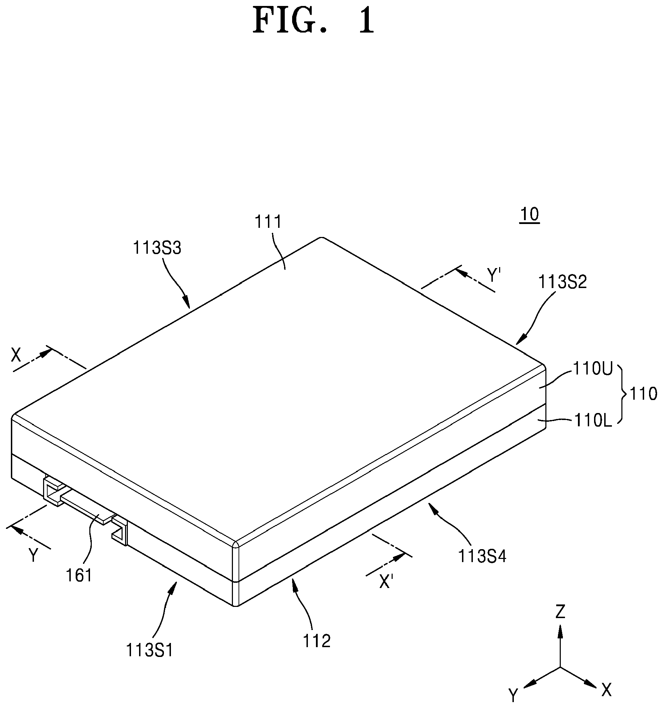

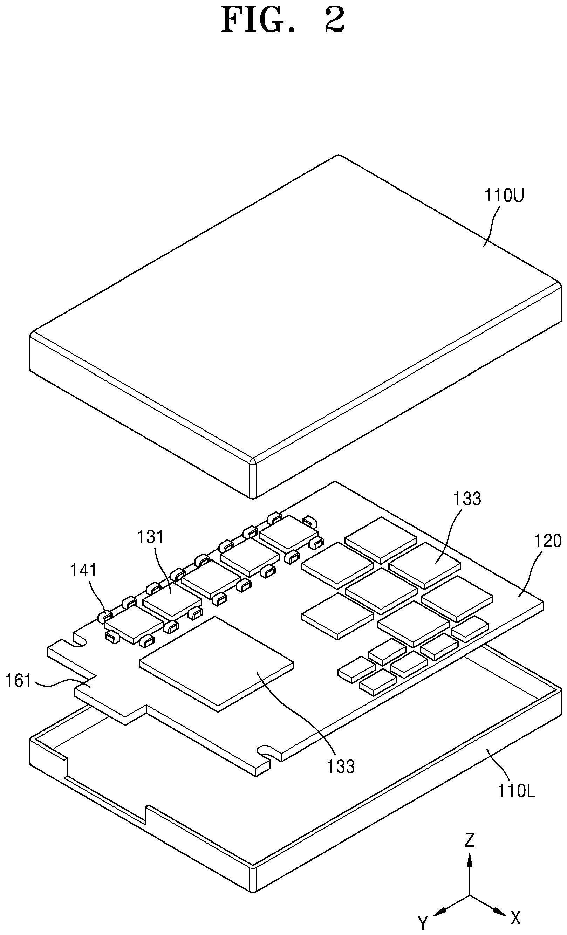

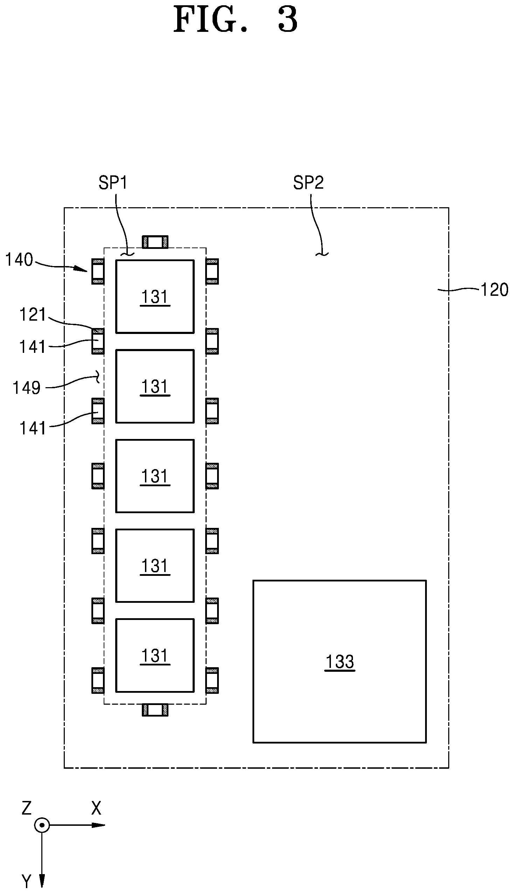

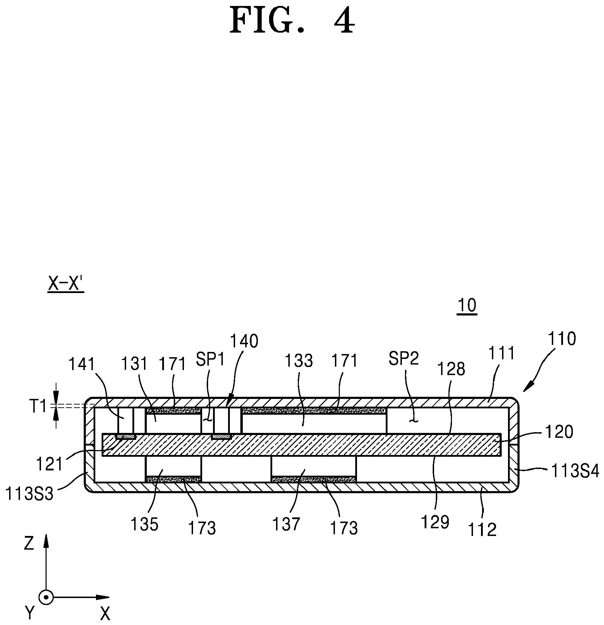

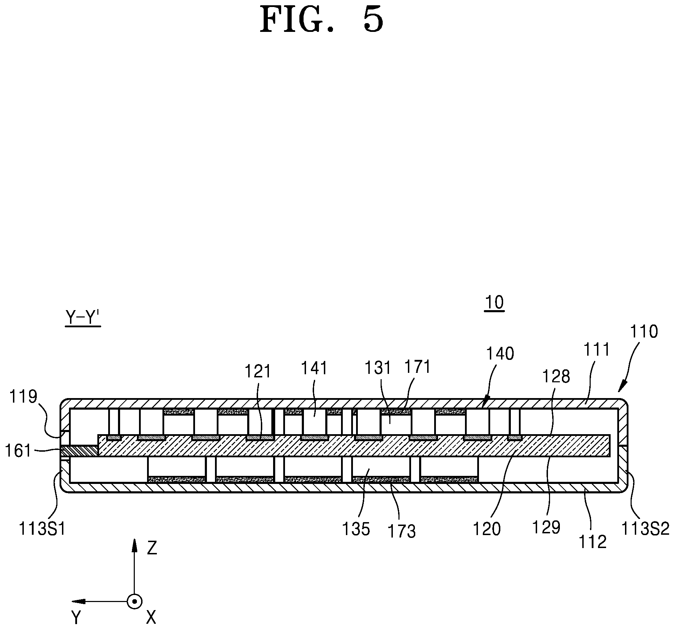

FIGS. 1 to 5 are diagrams illustrating a solid state drive (SSD) apparatus 10 according to embodiments. FIG. 1 is a perspective view showing the SSD apparatus 10. FIG. 2 is an exploded perspective view showing the SSD apparatus 10. FIG. 3 is a plan view showing some components of the SSD apparatus 10. FIG. 4 is a cross-sectional view of the SSD apparatus 10 taken along line X-X' of FIG. 1. FIG. 5 is a cross-sectional view of the SSD apparatus 10 along line Y-Y' of FIG. 1.

Referring to FIGS. 1 to 5, the SSD apparatus 10 may include a case 110, a substrate 120, semiconductor chips (e.g., first to fourth semiconductor chips 131, 133, 135, and 137), an external connector 161, and a first shielding structure 140.

The case 110 may form the exterior of the SSD apparatus 10. The case 110 may have a three-dimensional shape including an accommodation space in which various parts are accommodated. For example, the case 110 may include an upper wall 111 having a flat plate shape, a lower wall 112 having a flat plate shape, and side walls extending between the upper wall 111 and the lower wall 112. In example embodiments, the case 110 may have a hexahedral shape. The case 110 may include the upper wall 111 and the lower wall 112 that face or are opposite each other, a first side wall 113S1 and a second side wall 113S2 that face or are opposite each other, and a third side wall 113 S3 and a fourth side wall 113S4 that face or are opposite each other. Each of the third side wall 113 S3 and the fourth sidewall 113S4 may extend between the first side wall 113S1 and the second side wall 113S2. However, the shape of the case 110 is not limited to that described above, and the case 110 may have a polygonal column shape, such as a pentagonal column or a hexagonal column, or a circular column shape. The case 110 may be shaped like a prism, such as a pentagonal prism or a hexagonal prism, or a circular prism.

The case 110 may include an upper case 110U and a lower case 110L that are detachably coupled to each other. The upper case 110U may be coupled to the lower case 110L to form an accommodation space. The upper case 110U may include at least a portion of a sidewall of the case 110 and the upper wall 111 of the case 110, and the lower case 110L may include at least a portion of a sidewall of the case 110 and the lower wall 112 of the case 110.

The case 110 may include a material having high thermal conductivity to be suitable for dissipating heat generated from components disposed in the case 110, for example, the first to fourth semiconductor chips 131, 133, 135, and 137, to the outside of the case 110. For example, the thermal conductivity of the case 110 may be at least about 10 [W/(mK)] or higher. The case 110 may be made of a single material or a combination of different materials. The case 110 may include a metal, a carbon-based material, a polymer, or a combination thereof. The case 110 may include, for example, copper (Cu), aluminum (Al), zinc (Zn), tin (Sn), stainless steel, or a clad metal or alloy including these materials. Alternatively, the case 110 may include, for example, graphite, graphene, carbon fiber, a carbon nanotube composite, and the like. Alternatively, the case 110 includes, for example, epoxy resin, polymethylmethacrylate (PMMA), polycarbonate (PC), polyethylene (PE), polypropylene (PP), and the like.

The substrate 120 may be disposed within the accommodation space of the case 110. The substrate 120 may be disposed between the upper wall 111 and the lower wall 112. As the substrate 120 may be disposed between the upper wall 111 and the lower wall 112, the accommodation space of the case 110 may be divided into an upper accommodation space between the upper wall 111 and the substrate 120 and a lower accommodation space between the lower wall 112 and the substrate 120. The substrate 120 has a first surface 128 and a second surface 129 opposite to each other, and may have a generally flat plate shape. The first surface 128 of the substrate 120 faces the upper wall 111 and may be substantially parallel to the surface of the upper wall 111. The second surface 129 of the substrate 120 faces the lower wall 112 and may be substantially parallel to the surface of the lower wall 112. Hereinafter, the first direction (e.g., X direction) and the second direction (e.g., Y direction) are defined as directions parallel to the first surface 128 of the substrate 120, and the third direction (e.g., Z direction) is defined as a direction perpendicular to the first surface 128 of the substrate 120.

The substrate 120 may be a printed circuit board (PCB). For example, the substrate 120 may be a double-sided PCB or a multi-layer PCB. For example, the substrate 120 may include a base layer and interconnect layers. The interconnect layers may be formed on the upper and lower surfaces of the base layer and inside the base layer. The base layer may include at least one material selected from phenol resin, epoxy resin, and polyimide. The interconnect layers may include a conductive material, such as aluminum (Al), copper (Cu), nickel (Ni), or tungsten (W). Semiconductor chips and electronic components mounted on the substrate 120 may be electrically connected to each other through the interconnect layers of the substrate 120.

The external connector 161 may be coupled to or integrated with the substrate 120. The external connector 161 may be coupled to or extend from a first edge of the substrate 120 adjacent to the first side wall 113S1 of the case 110. The external connector 161 may be exposed to the outside of the SSD apparatus 10 through an opening 119 formed in the first side wall 113S1 of the case 110. The external connector 161 may be inserted into a socket of an external device outside the SSD apparatus 10 and may be configured to electrically connect the external device and the SSD apparatus 10 to each other. Through the external connector 161, the SSD apparatus 10 may be configured to transmit and receive electrical signals (e.g., control signals, data input/output signals, power signals, etc.) with external devices.

The SSD apparatus 10 may include at least one first semiconductor chip 131 and at least one second semiconductor chip 133 mounted on the first surface 128 of the substrate 120. In addition, the SSD apparatus 10 may include at least one third semiconductor chip 135 and at least one fourth semiconductor chip 137 mounted on the second surface 129 of the substrate 120.

The first to fourth semiconductor chips 131, 133, 135, and 137 may include a controller chip and memory semiconductor chips.

The controller chip may be configured to control a memory semiconductor chip. A control circuit unit or control circuit may be embedded in the controller chip. The control circuit unit of the controller chip may control access to data stored in the memory semiconductor chip. The control circuit unit of the controller chip may control write/read operations of a flash memory or the like according to a control command from an external host. The control circuit unit of the controller chip may include a separate control semiconductor chip, such as an application specific integrated circuit (ASIC). The control circuit unit of the controller chip may be configured to be automatically executed by an operating system of the external host when the SSD apparatus 10 is connected to the external host, for example. The control circuit unit of the controller chip may provide a standard protocol, such as parallel advanced technology attachment (PATA), serial advanced technology attachment (SATA), SCSI standard, or PCI Express (PCIe). In addition, the control circuit unit of the controller chip may perform wear leveling, garbage collection, bad block management, and error correction code for driving nonvolatile memory devices. In this case, the control circuit unit of the controller chip may include a script for automatic execution and an application program that may be executed in the external host.

The memory semiconductor chips may include a nonvolatile memory device and a volatile memory device. The nonvolatile memory device may include, for example, a flash memory, phase-change RAM (PRAM), resistive RAM (RRAM), ferroelectric RAM (FeRAM), and magnetic RAM (MRAM), etc., but is not limited thereto. The flash memory may be, for example, a NAND flash memory. The flash memory may be, for example, a V-NAND flash memory. The nonvolatile memory device may be formed of a single semiconductor die or may be a stack of several semiconductor dies. The volatile memory device may be, for example, dynamic random access memory (DRAM) or static RAM (SRAM), but is not limited thereto. The volatile memory device may provide a cache function for storing frequently used data when the external host accesses the SSD apparatus 10 and scale access-time and data-transfer performance to match the process performance of an external host connected to the SSD apparatus 10.

The first semiconductor chip 131 and the second semiconductor chip 133 may be physically and thermally coupled to the upper wall 111 of the case 110 through first thermal interface material (TIM) layers 171. The first TIM layers 171 may be disposed between the upper surface of the first semiconductor chip 131 and the upper wall 111 of the case 110 or between the second semiconductor chip 133 and the upper wall 111 of the case 110. The third semiconductor chip 135 and the fourth semiconductor chip 137 may be physically and thermally coupled to the lower wall 112 of the case 110 through second TIM layers 173. The second TIM layers 173 may be disposed between the lower surface of the third semiconductor chip 135 and the lower wall 112 of the case 110, or between the lower surface of the fourth semiconductor chip 137 and the lower wall 112 of the case 110.

The first TIM layers 171 and the second TIM layers 173 may each include a resin layer and a heat dissipating filler contained in the resin layer. The first TIM layers 171 and the second TIM layers 173 may be electrically nonconductive or electrically insulating.

The first shielding structure 140 may be disposed between the first surface 128 of the substrate 120 and the upper wall 111 of the case 110. The first shielding structure 140 may be in contact with the first surface 128 of the substrate 120 and the upper wall 111 of the case 110, respectively, and may electrically connect between a first connection pad 121 provided in or on the first surface 128 of the substrate 120 and the upper wall 111 of the case 110. In example embodiments, the first connection pad 121 of the substrate 120 may be configured to receive a ground voltage, and at least a portion of the first shielding structure 140 and the upper wall 111 of the case 110 may be electrically grounded.

The first shielding structure 140 may be disposed around the first semiconductor chips 131. The first shielding structure 140 may be disposed around the first semiconductor chips 131 to shield the first semiconductor chips 131 from electromagnetic interference (EMI), and also to protect the first semiconductor chips 131 and other electronic components from electrostatic discharge (ESD).

The first shielding structure 140 may be arranged to surround the first semiconductor chips 131. Between the upper wall 111 of the case 110 and the substrate 120, the first shielding structure 140 may define a first accommodation space SP1 accommodating the first semiconductor chips 131 and a second accommodation space SP2 accommodating the second semiconductor chips 133. That is, the upper accommodation space provided between the substrate 120 and the upper wall 111 of the case 110 may be partitioned or separated into a first accommodation space SP1 and a second accommodation space SP2. The first accommodation space SP1 may be surrounded by the first shielding structure 140 and inside the first shielding structure 140, and the second accommodation space SP2 may be outside the first shielding structure 140. Between the substrate 120 and the upper wall 111 of the case 110, the first semiconductor chips 131 may refer to chips accommodated in the first accommodation space SP1, and the second semiconductor chips 133 may refer to chips accommodated in the second accommodation space SP2. In example embodiments, the first semiconductor chips 131 may include a memory semiconductor chip, and the second semiconductor chips 133 may include a controller chip for controlling the first semiconductor chips 131.

In a plan view, the first shielding structure 140 may discontinuously extend along an imaginary line surrounding the plurality of first semiconductor chips 131. The first shielding structure 140 may include a plurality of first unit shielding structures or first shielding structure members 141 arranged along an imaginary line surrounding the plurality of first semiconductor chips 131. The plurality of first unit shielding structures 141 may be respectively disposed on the first connection pads 121 of the substrate 120. The lower part of the individual first unit shielding structure 141 may be physically and electrically connected to the corresponding first connection pad 121, and an upper portion of the individual first unit shielding structure 141 may physically and electrically contact the upper wall 111 of the case 110. The plurality of first unit shielding structures 141 may be spaced apart from each other with a slit 149 between each pair of neighboring first unit shielding structures 141. The slit 149 may be referred to as a first slit. The slit 149 may be a space or a gap formed by separating two neighboring first unit shielding structures 141 from among the plurality of first unit shielding structures 141.

As the first shielding structure 140 is formed to have slits 149, the first accommodation space SP1 and the second accommodation space SP2 may communicate with each other, and airflow may be allowed between the first accommodation space SP1 and the second accommodation space SP2. In example embodiments, a cooling fan configured to generate airflow for cooling the SSD apparatus 10 may be provided outside the SSD apparatus 10 and/or inside the SSD apparatus 10. In this case, the airflow generated by the cooling fan flows between the first accommodation space SP1 and the second accommodation space SP2 through the slits 149 of the first shielding structure 140, and the first semiconductor chips 131 in the first accommodation space SP1 may be cooled by the airflow generated by the cooling fan.

In example embodiments, at least some of the first semiconductor chips 131 may be arranged along a first straight line parallel to a first direction (e.g., X direction) or a second direction (e.g., Y direction), and a plurality of first unit shielding structures 141 may be arranged along a second straight line parallel to the first straight line. At this time, in the first unit shielding structures 141 arranged along the second straight line, an interval or spacing between two neighboring first unit shielding structures 141 may be between about 10% and about 300%, between about 10% and about 250%, between about 10% and about 200%, between about 10% and about 150%, between about 10% and about 100%, or between about 10% and about 50% of the length of one of the first semiconductor chips 131 in the first straight line. For example, in the first unit shielding structures 141 arranged along the second straight line, the interval between two neighboring first unit shielding structures 141 may be between about 1 mm and about 30 mm, between about 1 mm and about 25 mm, between about 1 mm and about 20 mm, between about 1 mm and about 15 mm, between about 1 mm and about 10 mm, or between about 1 mm and about 5 mm.

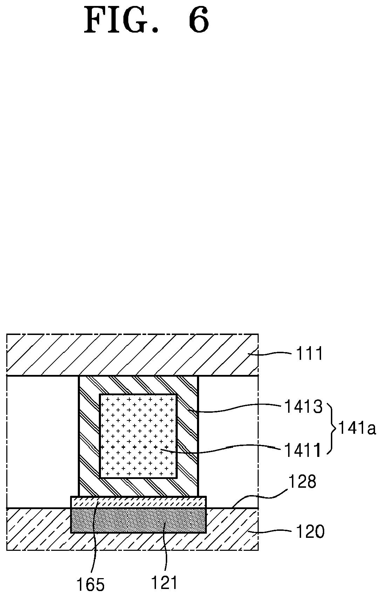

In example embodiments, individual first unit shielding structures 141 may be physically coupled to corresponding first connection pads 121. For example, the individual first unit shielding structure 141 may be physically fixed and coupled to the first connection pad 121 through a conductive adhesive material layer (165 of FIG. 6). For example, the conductive adhesive material layer 165 may include a metal, such as solder.

In embodiments, the individual first unit shielding structure 141 may have a preset elasticity or resilience. As the individual first unit shielding structure 141 may have elasticity, the individual first unit shielding structure 141 may be physically deformed by an external force. For example, the individual first unit shielding structure 141 is configured to contract and expand in a third direction (e.g., Z direction), and the length of the individual first unit shielding structure 141 in the third direction (e.g., Z direction) may be configured to be contracted or reduced by external force. That is, the length of the individual first unit shielding structure 141 in the third direction (e.g., Z direction) may decrease from the original initial length due to external force. For example, when assembling the SSD apparatus 10, the substrate 120 may be assembled with the case 110 so that a dimension in the third direction (e.g., Z direction) between the upper wall 111 of the case 110 and the substrate 120 becomes a target dimension. At this time, the target dimension in the third direction (e.g., Z direction) between the substrate 120 and the upper wall 111 of the case 110 may be less than the original initial length of the individual first unit shielding structure 141 in the third direction (e.g., Z direction). Accordingly, when the assembly between the substrate 120 and the case 110 is completed, the length of the individual first unit shielding structure 141 between the substrate 120 and the upper wall 111 of the case 110 in the third direction (e.g., Z direction) may be reduced from the original initial length. In embodiments, the difference T1 between the original initial length of the individual first unit shielding structure 141 and the deformed length of the individual first unit shielding structure 141 resulting from assembly between the substrate 120 and the case 110 may be between about 0.1 mm and about 1 mm or between about 0.3 mm and about 0.8 mm.

Since the individual first unit shielding structure 141 may be contracted or compressed by an external force acting between the assembled substrate 120 and the case 110, the individual first unit shielding structure 141 may maintain a state in close contact with the upper wall 111 of the case 110 by its own restoring force. That is, contact between the individual first unit shielding structure 141 and the upper wall 111 of the case 110 may be achieved by the restoring force of the individual first unit shielding structure 141 without a separate adhesive material. The restoring force may mean that the first unit shielding structure 141 may return to its original initial length when the external force is removed.

For example, the individual first unit shielding structure 141 may include an elastic body having a preset elasticity and a conductor connected to the elastic body. In the individual first unit shielding structure 141, the conductor makes electrical connection between the first connection pad 121 of the substrate 120 and the upper wall 111 of the case 110 and the elastic body may provide restoring force for maintaining contact between the conductor and the upper wall 111 of the case 110.

In example embodiments, the individual first unit shielding structure 141 may include a surface mounting gasket or a pogo-pin.

In example embodiments, the case 110 may include a plurality of grooves respectively accommodating the plurality of first unit shielding structures 141. The plurality of grooves of the case 110 may be defined by or in the surface of the upper wall 111 of the case 110 facing the substrate 120. An upper portion of the individual first unit shielding structure 141 may be accommodated in the groove of the case 110. In other embodiments, the surface of the upper wall 111 of the case 110 may have a flat or convex shape at a portion in contact with the individual first unit shielding structure 141.

In an SSD apparatus according to a comparative example (not shown), an EMI shielding structure for EMI shielding may be coupled to each of a substrate and a case through a conductive adhesive material. In this case, when the assembly between the substrate and the case is completed, the EMI shielding structure may be physically deformed by an external force, and the shielding performance of the EMI shielding structure is deteriorated due to the physical deformation of the EMI shielding structure.

However, according to the SSD apparatus 10 according to embodiments, since the first shielding structure 140 maintains a state in close contact with the case 110 by its restoring force, even if there is deformation of parts, machining errors of parts, assembly errors, and the like, physical contact between the first shielding structure 140 and the case 110 may be achieved without physical damage to the first shielding structure 140. Accordingly, the structural reliability of the first shielding structure 140 may be improved, and the reliability of EMI shielding and ESD shielding performance using the first shielding structure 140 may be improved.

FIG. 6 is a cross-sectional view illustrating a first unit shielding structure 141a of the first shielding structure 140 according to embodiments.

Referring to FIG. 6 and FIG. 4, the first unit shielding structure 141a may include an elastic body 1411 and a conductor 1413 connected to the elastic body 1411. The elastic body 1411 may include a material having preset elasticity, for example, sponge, rubber, or a spring. The conductor 1413 may make electrical connection between the upper wall 111 of the case 110 and the first connection pad 121 of the substrate 120. For example, the conductor 1413 may include metal. In example embodiments, the elastic body 1411 may be a sponge, and the conductor 1413 may be a conductive plating layer formed on an outer surface of the sponge. The conductor 1413 may include a lower portion connected to the first connection pad 121 of the substrate 120, an upper portion connected to the upper wall 111 of the case 110, and a middle or central portion electrically connecting the upper portion to the lower portion. In example embodiments, a conductive adhesive material layer 165 physically and electrically connecting the lower portion of the conductor 1413 to the first connection pad 121 of the substrate 120 may be disposed between the lower portion of the conductor 1413 and the first connection pad 121 of the substrate 120. When the assembly of the SSD apparatus 10 is completed, the length of the elastic body 1411 in the third direction (e.g., Z direction) may be contracted or reduced relative to its original initial length, and may be maintained in contact with the upper wall 111 of the case 110 by the restoring force provided by the elastic body 1411 in the third direction (e.g., the Z direction). In some embodiments, the elastic body 1411 is an electrical conductor, and the elastic body 1411 may be configured to electrically connect between the upper portion of the conductor 1413 and the lower portion of the conductor 1413.

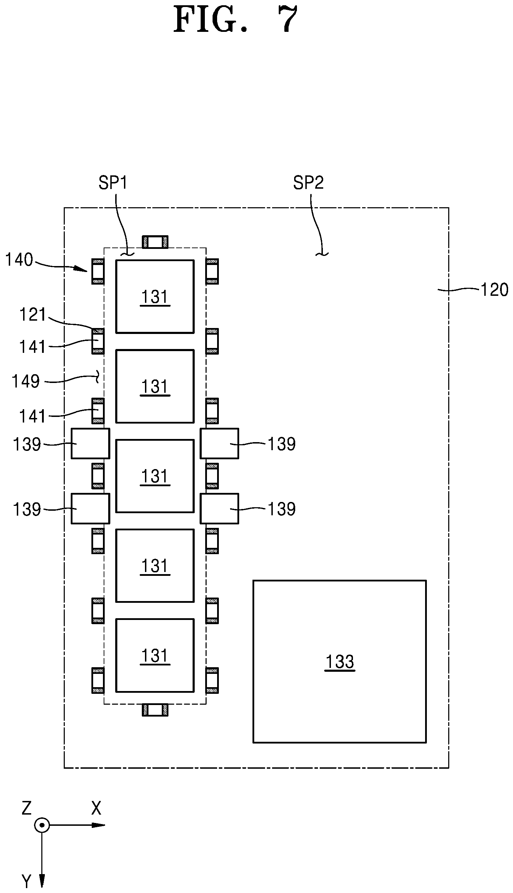

FIGS. 7 to 9 are plan views illustrating SSD apparatuses according to embodiments. Hereinafter, differences are mainly described between the SSD apparatuses shown in FIGS. 7 to 9 and the SSD apparatus 10 previously described with reference to FIGS. 1 to 5.

Referring to FIG. 7, the SSD apparatus may include electronic components 139 mounted on a first surface (128 of FIG. 4) of a substrate 120. The electronic components 139 may include, for example, semiconductor chips, passive elements, and/or active elements. Each of the electronic components 139 may be disposed between two neighboring first unit shielding structures 141 among the plurality of first unit shielding structures 141. That is, each of the electronic components 139 may be disposed in the slit 149 provided between two neighboring first unit shielding structures 141. Among the plurality of first unit shielding structures 141, two neighboring first unit shielding structures 141 may be spaced apart from each other through one or more electronic components 139.

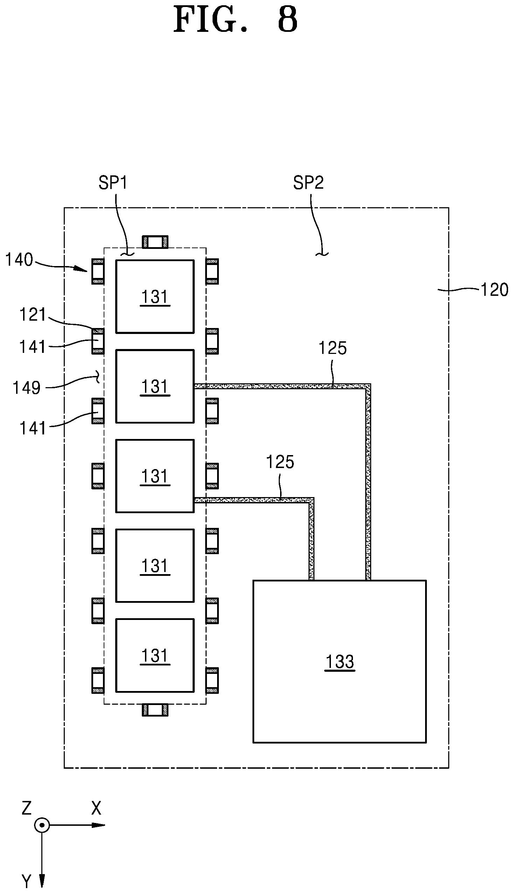

Referring to FIG. 8, in the SSD apparatus, the substrate 120 may include conductive signal transmission lines 125 extending across a region provided between two adjacent first unit shielding structures 141 among a plurality of first unit shielding structures 141. The signal transmission lines 125 may be formed in or on the first surface 128 of the substrate 120 and exposed to the outside of the substrate 120. In the substrate 120, the signal transmission lines 125 may extend across a region provided between two neighboring first connection pads 121 among the plurality of first connection pads 121. In a plan view, a part of an individual signal transmission line 125 may be located in a first accommodation space SP1, and the other part of the individual signal transmission line 125 may be located in a second accommodation space SP2. For example, the signal transmission lines 125 may be connected to the first semiconductor chip 131, and may be configured to transmit/receive a control signal, a data input/output signal, or a power signal (e.g., a driving voltage or a ground voltage) for the first semiconductor chip 131. In example embodiments, the signal transmission lines 125 may electrically connect at least one of the first semiconductor chips 131 to at least one of the second semiconductor chips 133.

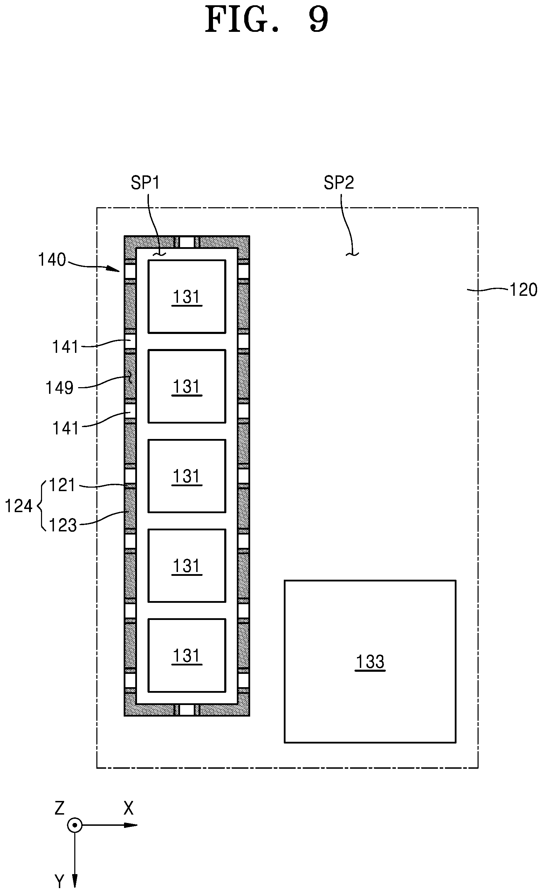

Referring to FIG. 9, the substrate 120 may include a ring-shaped pad 124 having a ring shape (e.g., a rectangular ring shape). In a plan view, the ring-shaped pad 124 may include a plurality of first connection pads 121 connected to a plurality of first unit shielding structures 141, and a conductive connection line 123 extending between two neighboring first connection pads 121 among the plurality of first connection pads 121. As the plurality of first connection pads 121 are connected through the conductive connection lines 123, the ring-shaped pad 124 may have a closed loop ring shape continuously extending to surround the first semiconductor chips 131. In this case, the plurality of first unit shielding structures 141 may be disposed on a ring-shaped pad 124 and spaced apart from each other along the ring-shaped pad 124. The plurality of first unit shielding structures 141 may be electrically connected to each other through the ring-shaped pad 124.

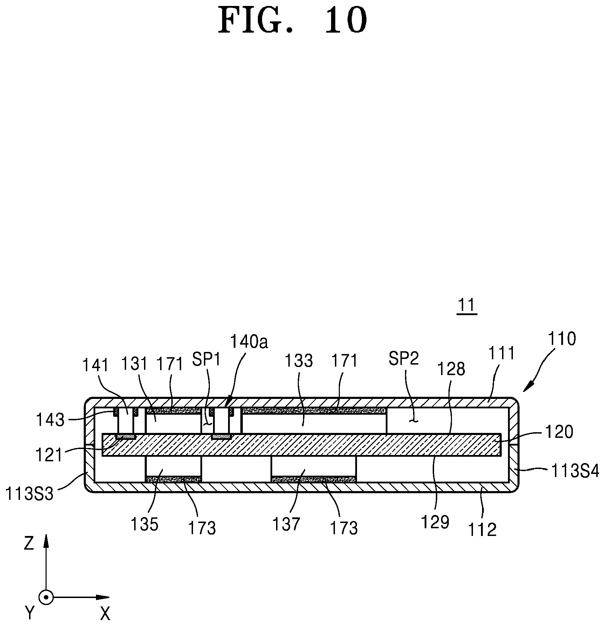

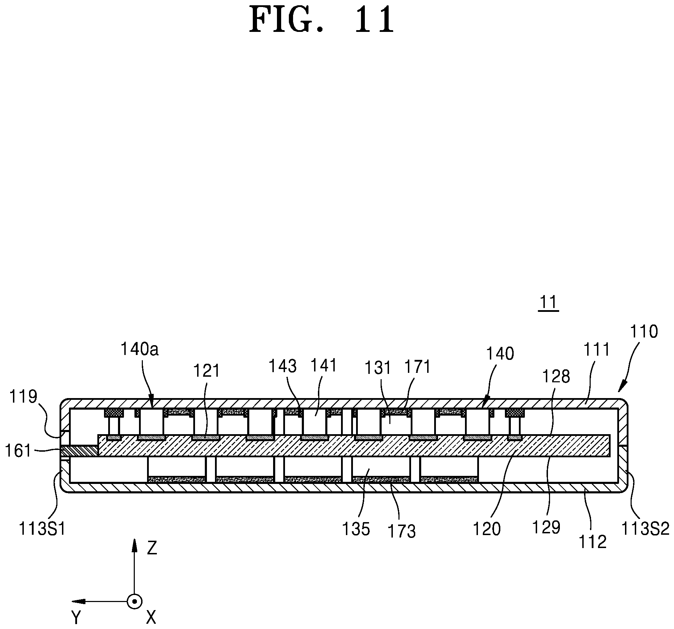

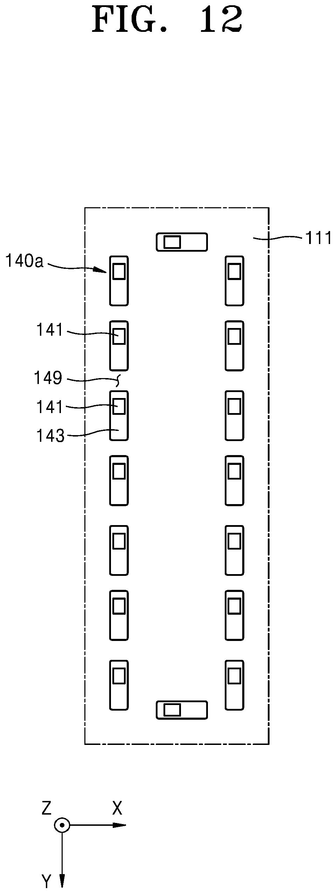

FIGS. 10 to 12 are diagrams showing an SSD apparatus 11 according to example embodiments. FIGS. 10 and 11 are cross-sectional views showing different cross-sections of the SSD apparatus 11. FIG. 12 is a plan view showing some components of the SSD apparatus 11. Hereinafter, in the interest of brevity, differences are mainly described between the SSD apparatus 11 shown in FIGS. 10 to 12 and the SSD apparatus 10 previously described with reference to FIGS. 1 to 5.

Referring to FIGS. 10 to 12, in the SSD apparatus 11, a first shielding structure 140a may include a plurality of the first unit shielding structure 141 physically and electrically coupled to the upper wall 111 of the case 110. For example, coupling between the plurality of first unit shielding structures 141 and the upper wall 111 of the case 110 may be achieved through a conductive adhesive material layer (e.g., a solder layer) or a fastening member, such as a screw. In example embodiments, the SSD apparatus 11 may include a plurality of brackets 143 on which a plurality of first unit shielding structures 141 are mounted. An individual bracket 143 may be fixedly coupled to the case 110 and may support the individual first unit shielding structure 141 such that the corresponding individual first unit shielding structure 141 is fixed and coupled to the upper wall 111 of the case 110.

The individual first unit shielding structure 141 is configured to contract and expand in a third direction (e.g., Z direction), and the length of the individual first unit shielding structure 141 in the third direction (e.g., Z direction) may be configured to be contracted or reduced by external force. When the assembly between the substrate 120 and the case 110 is completed, the length of the individual first unit shielding structure 141 between the substrate 120 and the upper wall 111 of the case 110 in the third direction (e.g., Z direction) may be reduced from the original initial length, and the individual first unit shielding structure 141 may maintain a state in close contact with the first connection pad 121 of the substrate 120 by its own restoring force. Contact between the individual first unit shielding structure 141 and the first connection pad 121 of the substrate 120 may be achieved by the restoring force of the individual first unit shielding structure 141 without a separate adhesive material. For example, the individual first unit shielding structure 141 may include an elastic body having a preset elasticity and a conductor connected to the elastic body. In the individual first unit shielding structure 141, the conductor makes electrical connection between the first connection pad 121 of the substrate 120 and the upper wall 111 of the case 110 and the elastic body may provide restoring force for contact between the conductor and the first connection pad 121 of the substrate 120. For example, in the individual first unit shielding structure 141, the upper portion of the conductor may be fixedly coupled to the upper wall 111 of the case 110 by the bracket 143, and the lower portion of the conductor may contact the corresponding first connection pad 121 by the restoring force provided by the elastic body.

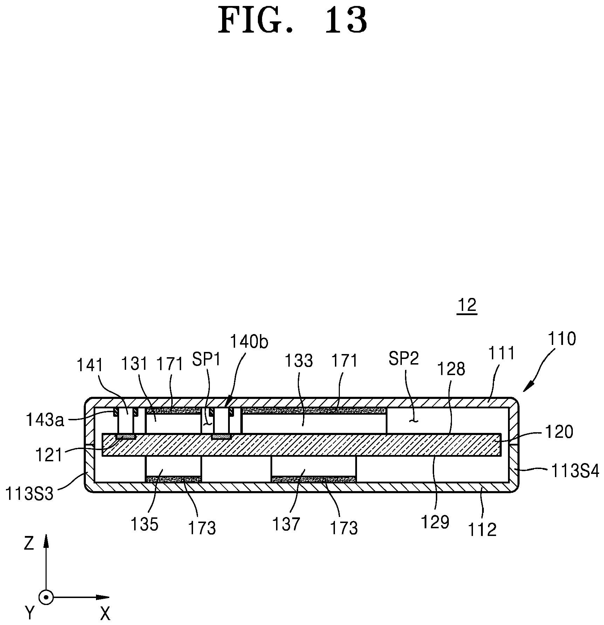

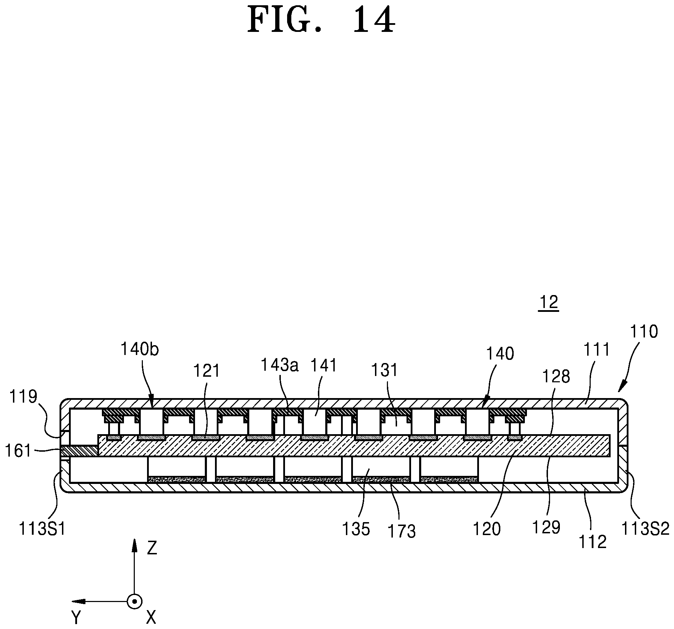

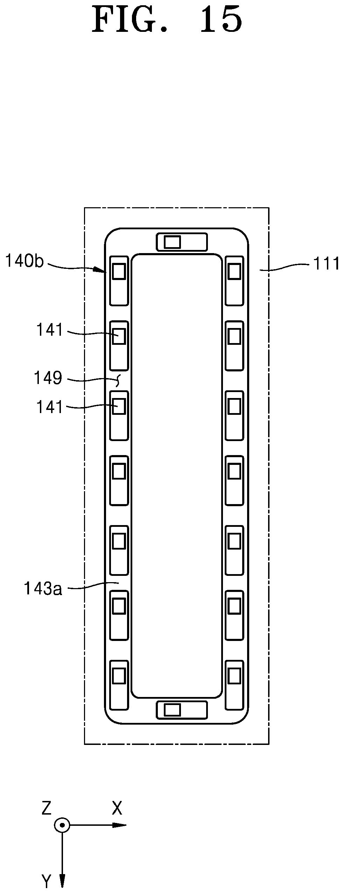

FIGS. 13 to 15 are diagrams showing an SSD apparatus 12 according to example embodiments. FIGS. 13 and 14 are cross-sectional views showing different cross-sections of the SSD apparatus 12. FIG. 15 is a plan view showing some components of the SSD apparatus 12. Hereinafter, in the interest of brevity, difference are mainly described between the SSD apparatus 12 shown in FIGS. 13 to 15 and the SSD apparatus 11 previously described with reference to FIGS. 10 to 12.

Referring to FIGS. 13 to 15, in the SSD apparatus 12, the plurality of first unit shielding structures 141 of a first shielding structure 140b may be mounted on a single bracket 143a. The single bracket 143a may have a closed loop ring shape (e.g., rectangular ring shape) continuously extending to surround the first semiconductor chips 131. The single bracket 143a may be fastened to the case 110 by a fastening member, such as a screw, and may support a plurality of first unit shielding structures 141 such that the plurality of first unit shielding structures 141 are fixed and coupled to the upper wall 111 of the case 110.

In embodiments, the single bracket 143a may be electrically conductive. For example, the single bracket 143a may be formed of metal. The plurality of first unit shielding structures 141 may be electrically connected to each other through a single bracket 143a. In example embodiments, the plurality of first unit shielding structures 141 and the single bracket 143a may be electrically grounded. Together with the plurality of first unit shielding structures 141, the single bracket 143a may protect the first semiconductor chips 131 and other electronic components around the first semiconductor chips 131 from EMI and ESD. In other embodiments, the single bracket 143a may be electrically non-conductive.

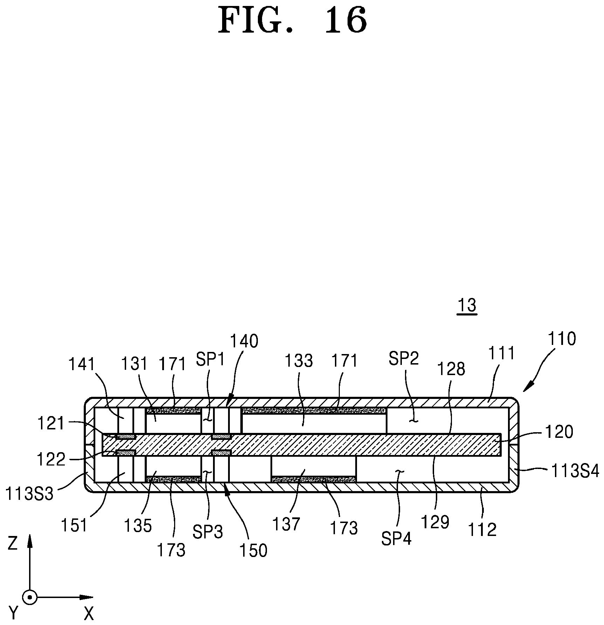

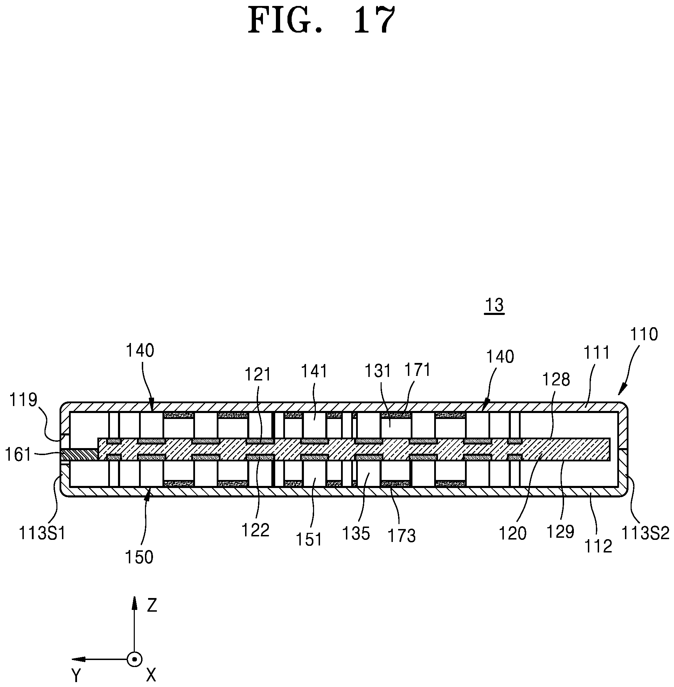

FIGS. 16 and 17 are cross-sectional views showing different cross-sections of an SSD apparatus 13 according to embodiments. Hereinafter, in the interest of brevity, differences are mainly described between the SSD apparatus 13 shown in FIGS. 16 and 17 and the SSD apparatus 10 previously described with reference to FIGS. 1 to 5.

Referring to FIGS. 16 and 17, the SSD apparatus 13 may further include a second shielding structure 150 disposed between the second surface 129 of the substrate 120 and the lower wall 112 of the case 110. The second shielding structure 150 may electrically connect a second connection pad 122 provided in or on the second surface 129 of the substrate 120 to the lower wall 112 of the case 110. In example embodiments, the second connection pad 122 of the substrate 120 is configured to receive a ground voltage, and at least a portion of the second shielding structure 150 and the lower wall 112 of the case 110 may be electrically grounded. The second shielding structure 150 may be disposed to surround the third semiconductor chips 135. The second shielding structure 150 may be disposed around the third semiconductor chips 135 to shield the third semiconductor chips 135 from EMI and also protect the third semiconductor chips 135 and other electronic components from ESD.

The second shielding structure 150 may define a third accommodation space SP3 accommodating the third semiconductor chips 135. That is, the lower portion accommodation space provided between the substrate 120 and the lower wall 112 of the case 110 may be partitioned or separated into a third accommodation space SP3 and a fourth accommodation space SP4. The third accommodation space SP3 may be surrounded by the second shielding structure 150 and inside the second shielding structure 150, and the fourth accommodation space SP4 may be outside the second shielding structure 150. Between the substrate 120 and the lower wall 112 of the case 110, the third semiconductor chips 135 may refer to chips accommodated in the third accommodation space SP3, and the fourth semiconductor chips 137 may refer to chips accommodated in the fourth accommodation space SP4.

In a plan view, the second shielding structure 150 may discontinuously extend along an imaginary line surrounding the plurality of second semiconductor chips 133. The second shielding structure 150 may include a plurality of second unit shielding structures or second shielding structure members 151 arranged along an imaginary line surrounding the plurality of second semiconductor chips 133. The plurality of second unit shielding structures 151 may be spaced apart from each other with a slit, gap, or spacing between each pair of neighboring second unit shielding structures 151. The slit between two neighboring second unit shielding structures 151 may be referred to as a second slit. Since the plurality of second unit shielding structures 151 are substantially the same as the plurality of first unit shielding structures 141 described above, a detailed description thereof is omitted here in the interest of brevity.

In embodiments, an individual second unit shielding structure 151 may be physically and electrically connected to the individual second connection pads 122 of the substrate 120 through a conductive adhesive material layer (e.g., a solder layer), and contact between the individual second unit shielding structure 151 and the lower wall 112 of the case 110 is maintained by the restoring force of the elastic body included in the individual second unit shielding structure 151 without a medium, such as an adhesive.

In embodiments, the individual second unit structure 151 may be fixed and coupled to the lower wall 112 of the case 110, and contact between the individual second unit shielding structure 151 and the individual second connection pad 122 of the substrate 120 may be maintained by the restoring force of the individual second unit shielding structure 151 itself without a medium, such as an adhesive. In embodiments, a plurality of second unit structures may be mounted on a single ring-shaped bracket, and the plurality of second unit structures may be configured to be electrically connected to one another through a single bracket.

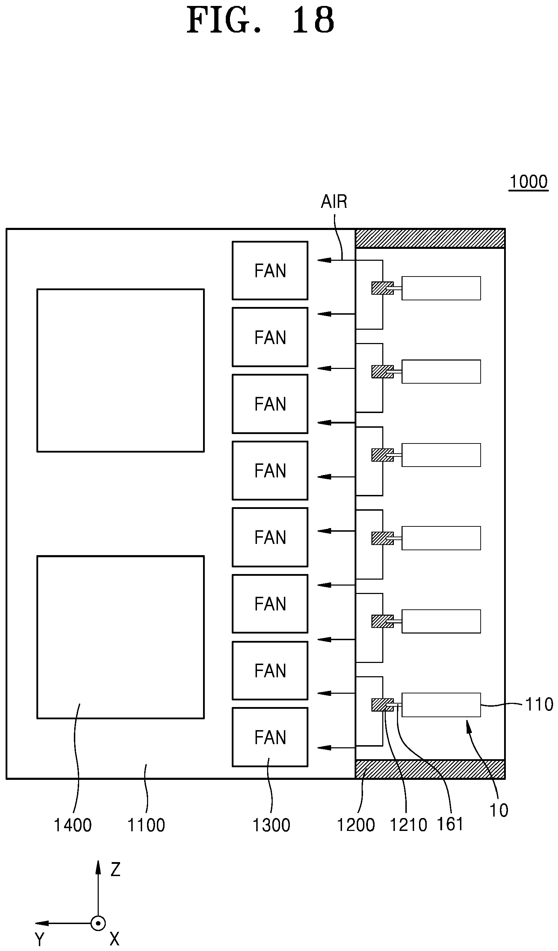

FIG. 18 is a configuration diagram illustrating a data storage apparatus according to embodiments.

Referring to FIG. 18 and FIGS. 1 to 5, a data storage apparatus 1000 may be, for example, a storage device, such as a Direct Attached Storage (DAS), a Network Attached Storage (NAS), or a Storage Area Network (SAN).

The data storage apparatus 1000 may include a rack 1200 on which the SSD apparatus 10 is mounted, and a cooling fan 1300 disposed adjacent to the rack 1200. The SSD apparatus 10 is illustrated as the SSD apparatus 10 described with reference to FIGS. 1 to 5, but the data storage apparatus 1000 may include any of the SSD apparatus described with reference to FIGS. 7 to 17. The rack 1200 and the cooling fan 1300 may be disposed on a support substrate 1100, such as a PCB. In addition, the data storage apparatus 1000 may further include a power supply unit 1400 for supplying power necessary for driving the data storage apparatus 1000, and a processing unit, such as a CPU, for controlling driving of the data storage apparatus 1000.

The rack 1200 may include a plurality of sockets 1210 spaced apart from each other in a third direction (e.g., Z direction), and one SSD apparatus 10 may be inserted into each of the plurality of sockets 1210. The SSD apparatus 10 may be coupled to the socket 1210 provided in the rack 1200 by sliding in the second direction (e.g., Y direction), for example. When the external connector 161 of the SSD apparatus 10 is coupled to the socket 1210, the SSD apparatus 10 and the socket 1210 may be physically and electrically connected to each other.

The cooling fan 1300 may provide a forced convection environment within the data storage apparatus 1000. For example, the cooling fan 1300 may form an air current flowing in the second direction (Y direction) within the data storage apparatus 1000. For example, the cooling fan 1300 may be a suction fan. Airflow generated by the cooling fan 1300 may cool the SSD apparatus 10.

According to embodiments, since a shielding structure is disposed around semiconductor chips, it is possible to protect semiconductor chips from EMI and ESD. Accordingly, the reliability of an SSD apparatus may be improved. Furthermore, according to embodiments, since a shielding structure is configured to remain in close contact with a substrate and/or a case by its own restoring force, the contact reliability between the shielding structure and the substrate and/or the case may be improved, and thus, the reliability of EMI shielding and ESD shielding performance using the shielding structure may be improved when at least one of the shielding structure, the substrate and the case is electrically grounded.

While the inventive concept has been particularly shown and described with reference to embodiments thereof, it will be understood that various changes in form and details may be made therein without departing from the scope of the following claims.

## Claims

1. A solid state drive (SSD) apparatus comprising:
a case including an upper wall and a lower wall;
a substrate in the case and including a plurality of first connection pads in or on a first surface of the substrate facing the upper wall of the case;
a first semiconductor chip on the first surface of the substrate; and
a first shielding structure electrically connecting the upper wall of the case to the plurality of first connection pads,
wherein the first shielding structure comprises a plurality of first unit shielding structures surrounding the first semiconductor chip and spaced apart from each other with gaps therebetween,
wherein each of the plurality of first unit shielding structures comprises an elastic body, and
wherein at least one of the upper wall of the case, the plurality of first unit shielding structures, and the plurality of first connection pads is electrically grounded.

2. The SSD apparatus of claim 1, wherein the upper wall of the case, the plurality of first unit shielding structures, and the plurality of first connection pads are electrically grounded.

3. The SSD apparatus of claim 1 or 2, wherein a space between the substrate and the upper wall of the case comprises:
a first accommodation space surrounded by the first shielding structure with the first semiconductor chip in the first accommodation space; and
a second accommodation space outside the first shielding structure,
wherein the first accommodation space and the second accommodation space communicate with each other through the gaps of the first shielding structure.

4. The SSD apparatus of claim 3, further comprising a second semiconductor chip on the first surface of the substrate in the second accommodation space.

5. The SSD apparatus of any preceding claim, wherein each of the plurality of first unit shielding structures comprises a surface mounting gasket or a pogo-pin.

6. The SSD apparatus of any preceding claim, wherein the plurality of first unit shielding structures are physically and electrically coupled to the plurality of first connection pads,
wherein each of the plurality of first unit shielding structures is in contact with the upper wall of the case by a restoring force of the elastic body.

7. The SSD apparatus of claim 6, wherein each of the plurality of first unit shielding structures further comprises a conductor in contact with the upper wall of the case by the restoring force of the elastic body.

8. The SSD apparatus of any one of claims 1 to 5, wherein the plurality of first unit shielding structures are physically and electrically coupled to the upper wall of the case,
wherein each of the plurality of first unit shielding structures is in contact with a corresponding first connection pad among the plurality of first connection pads by a restoring force of the elastic body.

9. The SSD apparatus of claim 8, wherein each of the plurality of first unit shielding structures further comprises a conductor in contact with a corresponding first connection pad among the plurality of first connection pads by the restoring force of the elastic body.

10. The SSD apparatus of claim 8 or 9, wherein the first shielding structure further comprises a single bracket on which the plurality of first unit shielding structures are mounted,
wherein the single bracket is coupled to the case.

11. The SSD apparatus of claim 10, wherein the plurality of first unit shielding structures are electrically connected to each other through the single bracket.

12. The SSD apparatus of any preceding claim, further comprising:
a third semiconductor chip on a second surface of the substrate opposite to the first surface of the substrate; and
a second shielding structure including a plurality of second unit shielding structures between the second surface of the substrate and the lower wall of the case,
wherein the plurality of second unit shielding structures surround the third semiconductor chip and are spaced apart from each other with gaps therebetween,
wherein the substrate further comprises a plurality of second connection pads which are electrically grounded and which are in or on the second surface of the substrate,
wherein the plurality of second unit shielding structures electrically connect the lower wall of the case to the plurality of second connection pads, and
wherein each of the plurality of second unit shielding structures comprises an elastic body.

13. The SSD apparatus of any preceding claim, further comprising an external connector connected to the substrate,
wherein the external connector extends outside of the case through an opening of the case.

14. The SSD apparatus of any preceding claim, further comprising an electronic component on the first surface of the substrate between neighboring ones of the plurality of first unit shielding structures.

15. The SSD apparatus of any preceding claim, wherein the substrate further comprises a signal transmission line extending across a region between neighboring ones of the plurality of first connection pads.
